(19)

**Europäisches Patentamt**
**European Patent Office**
**Office européen des brevets**

(11) **EP 4 260 152 B1**

(12) **EUROPEAN PATENT SPECIFICATION**

(45) Date of publication and mention
of the grant of the patent:
**26.11.2025 Bulletin 2025/48**

(21) Application number: **22701334.9**

(22) Date of filing: **13.01.2022**

(51) International Patent Classification (IPC):
**G05B 23/02** *(2006.01)* **G06F 30/20** *(2020.01)*

(52) Cooperative Patent Classification (CPC):
**G05B 23/0248;** G06F 30/20

(86) International application number:
**PCT/EP2022/050607**

(87) International publication number:
**WO 2022/157062 (28.07.2022 Gazette 2022/30)**

(54) **COMPUTER-IMPLEMENTED METHOD AND DEVICE FOR RESOLVING CLOSED LOOPS IN AUTOMATIC FAULT TREE ANALYSIS OF A MULTI-COMPONENT SYSTEM**

COMPUTERIMPLEMENTIERTES VERFAHREN UND VORRICHTUNG ZUR AUFLÖSUNG GESCHLOSSENER SCHLEIFEN BEI DER AUTOMATISCHEN FEHLERBAUMANALYSE EINES MEHRKOMPONENTENSYSTEMS

PROCÉDÉ ET DISPOSITIF MIS EN OEUVRE PAR ORDINATEUR POUR RÉSOUDRE DES BOUCLES FERMÉES DANS UNE ANALYSE AUTOMATIQUE PAR ARBRE DE DÉFAILLANCES D'UN SYSTÈME À PLUSIEURS COMPOSANTS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.01.2021 EP 21152987**

(43) Date of publication of application:
**18.10.2023 Bulletin 2023/42**

(73) Proprietor: **Siemens Industry Software NV**
**3001 Leuven (BE)**

(72) Inventors:
• **MENU, Jonathan**
**3018 Wijgmaal (BE)**

• **MONTRONE, Francesco**
**85521 Riemerling (DE)**
• **SALEH, Amr Hany**
**3000 Leuven (BE)**
• **ZELLER, Marc**
**81243 München (DE)**

(74) Representative: **Siemens Patent Attorneys**
**Postfach 22 16 34**
**80506 München (DE)**

(56) References cited:
**EP-A1- 3 579 074**

## Description

The present invention pertains to a computer-implemented method for resolving closed loops in automatic fault tree analysis of a multi-component system. The present invention further pertains to a device comprising a processor configured to perform such a method.

### 1. Technical field

The present invention pertains to a computer-implemented method for resolving closed loops in automatic fault tree analysis of a multi-component system. The present invention further pertains to a device comprising a processor configured to perform such a method.

### 2. Prior art

The importance of safety-critical systems in many application domains of embedded systems, such as aerospace, railway, health care, automotive and industrial automation is continuously growing. Thus, along with the growing system complexity, the need for safety assurance as well as its effort is increasing in order to guarantee the high quality demands in these application domains. The aim of safety assurance is to ensure that systems do not lead to hazardous situations which may harm people or endanger the environment. In the application domains of safety-critical systems, the safety assurance is defined by the means of standards, see, e.g., International Electrotechnical Commission (IEC) 61508, "Functional Safety of Electrical/Electronic/Programmable Electronic Safety-related Systems," 1998.

Traditionally, the assessment of a system in terms of safety is based on a bottom-up safety analysis approach, such as Failure Mode and Effect Analysis (FMEA), see IEC 60812, "Analysis Techniques for System Reliability - Procedure for Failure Mode and Effects Analysis (FMEA)," 1991. Alternatively, the assessment of a system according to reference implementations is based on top-down approaches such as Fault Tree Analysis (FTA), see, e.g., Vesely et al., "Fault Tree Handbook," US Nuclear Regulatory Commission, 1981. By such techniques, it is possible to identify system failure states, their causes and effects with impact on the system safety.

Often architectures of systems contain loops. An example for a loop is a closed-loop controller (PID). Closed-loop control refers to the process in which a physical variable, e. g., an ambient temperature, is to be brought to a particular value while being stabilized against disturbances. A feedback - obtained based on measuring an observable indicative of the physical variable - is used to set operation of an actuator influencing the physical variable. The controller is the component that acquires the actual value and derives a control signal from the difference between the set point and actual value. The controller then activates a final controlling element, e. g., a heater, that compensates for the control deviation.

Since failure propagation models often use Boolean logic, e.g., to drive a fault tree (FT), (closed) loops or ring closures are problematic. Because Boolean logic cannot contain loops in general, there are techniques to prevent loops in such models, e.g., as described in Höfig et al., "Streamlining Architectures for Integrated Safety Analysis Using Design Structure Matrices (DSMS)," Safety and Reliability: Methodology and Applications, 2014. For applications where failure propagation models are composed automatically, e.g., when the architecture is generated, such preventive technologies cannot help. Such loops often cannot be prevented, as they simply develop during the composition of a system from existing components and existing parts of failure propagation models. Therefore a technique is required that is able to deal with loops in failure propagation models that use Boolean logic.

In Yang et al., "Analytic Method to Break Logical Loops Automatically in PSA," Reliability Engineering & System Safety, 56(2):101 - 105, 1997, the authors automatically break open loops analytically. They use a top-down expansion of the Boolean equation until they detect a loop by addressing the same structural element in a conjunction twice. The term is then removed from the equation, arguing that a larger multiplication of basic events results in a smaller portion of the overall reliability. The result may become inexact and optimistic and the failure grows with the number of loops being detected.

In Cuenot et al., "Proposal for extension of meta-model for error failure and propagation analysis," Safe Automotive Software Architecture (SAFE), an ITEA2 project, 2013, the loops are removed from failure propagation models, but this work only addresses one-dimensional loops with only one entry and one exit point. Thus, it is not possible or only possibly to a limited degree to break open arbitrary loops that are multi-dimensional with multiple entry and exit points into other loops.

In Vaurio et al., "A Recursive Method for Breaking Complex Logic Loops in Boolean System Models," Reliability Engineering & System Safety, 92(10):1473 - 1475, 2007, the authors use a top-down method to expand the Boolean formula through all existing loops recursively. They stop this recursion after a step where further unrolling loops does not change the cut sets of the Boolean equation any more. It is assumed that this is a valid criterion for the termination of the algorithm, since the number of cut sets is finite. There is no proof that unrolling will not alternate between two solutions. Also, the number of cut sets grows exponential and so does the algorithm, which should be in $O(n^n)$.

Another approach can be found in Lim et al., "Systematic Treatment of Circular Logics in a Fault Tree Analysis," Nuclear Engineering and Design, 245 (Supplement C):172 - 179, 2012, where the initial condition of a system is investigated to treat circular logic. An initial condition of a circular logic is the point where the loop is closed. If the next gate is of the type "fails to run" or "fails to start", the circular logic is treated differently. These conditions indicate whether a supporting system is in standby and needs to be started to fulfill its function or if a system is running and fails to perform its operation. This knowledge is required for all gates of a fault tree logic that close a loop to automatically treat the circular logic using the algorithm. This limits the ability to fully automate the process of removing circular logic from automatically generated fault trees.

Against this background, a need exists for advanced techniques of analyzing safety-critical systems. In particular, a need exists for advanced techniques of identifying and resolving loops in fault trees.

Document EP 3 579 074 A1 discloses a method for resolving closed loops in automatic fault tree analysis of a multi-component system. The closed loops are first identified in a top-down approach within failure propagation paths. Next, the loops are resolved by setting each loop interconnection to Boolean TRUE, adjusting the fault tree in a specific way and finally setting each loop interconnection to Boolean FALSE.

It is therefore an objective of the invention to provide a computer-implemented method for resolving closed loops in automatic fault tree analysis of a multi-component system in an efficient and reliable manner.

3. Summary of the invention

This problem is according to one aspect of the invention solved by a computer-implemented method for resolving closed loops in automatic fault tree analysis of a multi-component system, the method comprising the steps:

   a. modeling the multi-component system using a fault tree, the fault tree comprising elements associated with components of the multi-component system and interconnections between the elements associated with functional dependencies between the components;

   b. back-tracing failure propagation paths from an output element of the fault tree via the interconnections towards one or more input elements of the fault tree;

   c. checking, for all failure propagation paths , if the respective failure propagation path contains a closed loop by identifying a downstream element of the respective failure propagation path having a dependency of its output value on an output value of an upstream element (4c) of the failure propagation path;

   d. setting the input value corresponding to a loop interconnection of each such downstream element to Boolean TRUE;

   e. Identifying any Boolean AND-gate having, independently of the specific values of the input elements, no Boolean TRUE as output value;
   cutting off any Boolean TRUE input to these identified Boolean AND-gate between the respective downstream element and the respective upstream element, and

   f. setting the input value of each respective downstream element corresponding to the loop interconnection to Boolean FALSE.

One idea of the present invention is to provide a method of resolving closed loops by following an approach inspired by fixed-point iteration, i.e. by a method of computing solutions of equations that can be written in the form $x = f(x)$. Given such a function defined on real numbers with real values and given a starting point $x_0$ in the domain of f, one can show that the sequence $x_{n+1} = f(x_n)$, n = 0, 1, 2... converges against a solution x of $x = f(x)$ under specific circumstances. In the present case, taking into account the underlying Boolean logic, only two values are possible for variables, namely Boolean TRUE and FALSE. A fault tree or failure propagation paths within the fault tree may be regarded as some form of equation or system of coupled equations. The present invention now considers Boolean TRUE as starting value to all failure propagation paths where a closed loop has been discovered, such closed loops being found by iteratively going through the fault tree from the output to one or more inputs. Based on that, certain properties of the fault tree are evaluated and the fault tree is amended in a specific way to remove any closed loop present in the fault tree. Subsequently, Boolean FALSE is inserted as second starting value to render the remaining fault tree analyzable.

The specifics of the method according to the invention will become more apparent further below with reference to exemplary embodiments depicted in the drawings as appended. In short, simple fault trees may already be solved by simply setting any loop interconnection to Boolean TRUE.

In case a tautology arises, which means that the output element of the fault tree gives Boolean TRUE independent of the values of the input elements, the loop interconnections have to be set to Boolean FALSE in a subsequent step, which then may render the fault tree analyzable, that is without any remaining loops.

However, for specific complex fault trees, problems may arise, which make it necessary to identify any Boolean AND-gate having, independently of the specific values of the input elements, no Boolean TRUE as output value. These inputs, namely the Boolean TRUE input to any Boolean AND-gate, are cut. Setting any loop interconnection to Boolean FALSE in the next step then renders any fault tree analyzable, which means that the remaining fault tree does not contain loops anymore and hence may be expressed as and/or expanded into a definite Boolean expression.

The method according to the invention results in a lower bound for the fault tree analysis. This means that the result of the Fault Tree analysis is either equal or larger the exact result of the fault tree.

The advantage is that the combination of demining a lower and in addition to an upper bound enables a clear judgment if safety requirements are fulfilled or not in most of the cases.

The solution according to the invention is highly effective compared to conventional methods. The method of the invention particularly features linear complexity O(n) and thus is much faster than any method known so far. The method may enable automatized optimization of technical products and/or systems with regards to reliability, availability, maintainability and/or safety (RAMS requirements). Moreover, such RAMS requirements may be taken into consideration for the optimization of further technical system properties like for example efficiency and so on. The invention particularly provides an advanced technique for analyzing safety-critical systems.

According to another aspect, the fault tree is expressed within Boolean algebra by iteratively expanding the fault tree into Boolean expressions at the elements.

According to another aspect, the closed loop of the fault tree is associated with a closed-loop control circuitry of the multi-component system.

A further aspect of the invention is a device comprising a processor configured to perform the aforementioned method.

4. Short description of the drawings

In the following detailed description, presently preferred embodiments of the invention are further described with reference to the following figures:

Fig. 1 shows a device with a processor performing a method according to the invention, resulting in a lower bound for the fault tree analysis.

Figs. 2-4 show a fault tree analyzed with the device of Fig 1.

Figs. 5 and 6 show fault trees according to an alternative embodiment, resulting in an upper bound for the fault tree analysis.

Figs. 7 and 8 show fault trees according to an embodiment resulting in a lower bound for the fault tree analysis.

Figs. 9 and 10 show fault trees according to an alternative embodiment, resulting in an upper bound for the fault tree analysis.

Figs. 11 and 12 show fault trees according to an embodiment resulting in a lower bound for the fault tree analysis.

5. Detailed description of preferred embodiments

Although specific embodiments are illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

Herein, techniques are described to reliably and computationally inexpensively detect closed loops and/or ring closures in fault trees (FT). For this, a plurality of failure propagation paths are back-traced from an output of the FT towards one or more inputs of the FT. Then, for each failure propagation path, a check can be made if the respective failure propagation path forms a closed loop. Then, if a closed loop is identified, it may be possible to take an appropriate counter measure to mitigate negative effects of the closed loop on the analyzability of the FT.

Generally, the techniques described herein may find application in various kinds and types of safety-critical systems. For example, the techniques described herein may find application in multi-component system, e.g. control or actuator systems. Such control or actuator systems may provide control functionality or activation functionality for certain machines. Some elements of multi-component safety-critical systems may be implemented as hardware while some components may alternatively or additionally be implemented using software. It is possible that the safety-critical systems for which the techniques are employed include an output which provides an actuator force or a control signal for actuating or controlling one or more machines. Specific examples of safety-critical systems which may benefit from the techniques described herein include, but are not limited to, electronic circuitry including active and/or passive electronic components such as transistors, coils, capacitors, resistors, etc.; drivetrains for vehicles such as trains or passenger cars or airplanes; assembly lines including conveyor belts, robots, movable parts, control sections, test sections for inspecting manufactured goods (backend testing); medical systems such as imaging systems including magnetic resonance imaging or computer tomography, particle therapy systems; power plants; etc.

As a general rule, in the various examples described herein, different kinds and types of FTs may be used. An example implementation of a FT that may be relied upon in the techniques described herein includes a component FT (CFT). For sake of simplicity, hereinafter, various examples are described in the context of CFTs - while, generally, also a FT may be employed.

CFTs are described, e.g., in Kaiser et al., "A new component concept for FTs," Proceedings of the 8th Australian Workshop on Safety Critical Systems and Software, Volume 33, pp. 37-46, 2003. CFTs provide a model- and component-based methodology for FT analysis, which supports a modular and compositional safety analysis strategy. The CFT includes a plurality of elements. The elements are associated with components of the system. The CFT also includes a plurality of interconnections between the elements. The interconnections are associated with functional dependencies between components of the system. Such functional dependencies may model input/output of control signals or flow of forces. The CFT may model an error behavior of the system. The error behavior of the system may be modeled by the CFT using approaches of hierarchical decomposition. Here, the overall behavior of the system can be predicted based on the individual behavior of components. In other words, the causal chain leading to an overall system behavior may be modeled by a causal chain of errors of components. The CFT may include Boolean interconnections between adjacent elements to model propagation of errors throughout the system. The CFT may model the system using a graph; here nodes of the graph may correspond to the elements and edges of the graph may correspond to the interconnections.

Various techniques described herein are based on the finding that CFTs modeling a system using Boolean logic expressions can malfunction if they include closed loops and/or ring closures. A closed loop may generally be present if an input value of an element of the CFT is derived from an output having an associated Boolean logic expression, which includes that input value.

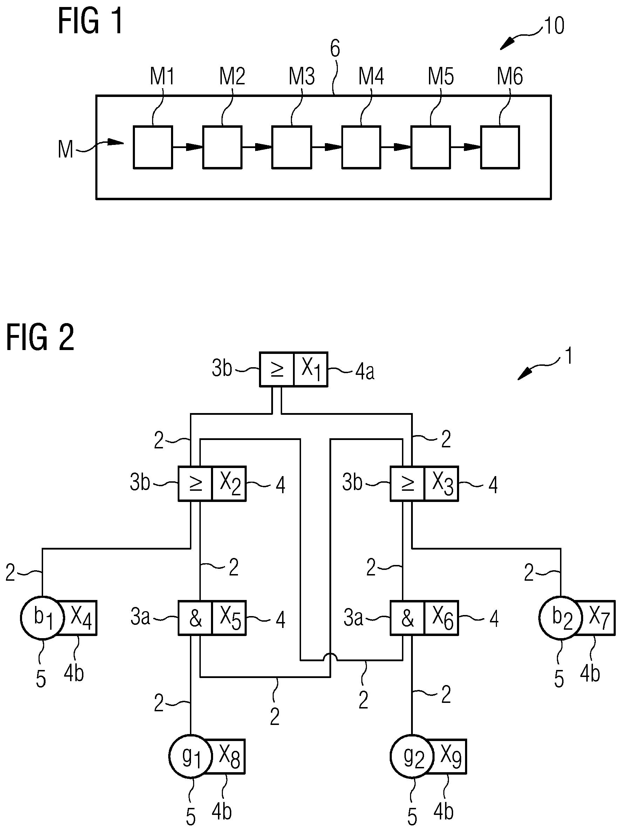

Figure 1 shows a device 10 with a processor 6 performing a method M according to the invention for resolving closed loops in automatic fault tree analysis of a multi-component system (not depicted). The multi-component system may be, for example, a safety critical system or the like, which may comprise closed-loop control circuitry of a closed-loop controller (PID). The PID may for example be configured to control a component of the multi-component system on basis of a closed control loop. The PID may for example control a physical variable like a temperature, a pressure, a force and so on.

The method M will be explained in detail with reference to Figs. 2 to 4 for one particular example of a fault tree 1. The fault tree 1 models a multi-component system and comprises a plurality of elements 4 associated with components of the multi-component system and interconnections 2 between the elements 4 associated with functional dependencies between the components. Accordingly, the method M comprises under M1 modeling the multi-component system using the fault tree 1. The fault tree 1 comprises one output element 4a and four input elements 4b. Each element 4 (labeled as $X_i$ with i = 1...9) is associated with either a gate 3 or an event 5. In this particular example, there are three Boolean OR-gates 3b and two Boolean AND-gates 3a. Further, there are different basic events $b_1$, $b_2$, $g_1$, $g_2$. As can be seen in Fig. 2, the gates $X_5$ and $X_6$ both have inputs stemming from gates upstream in the fault tree, namely from $X_3$ and $X_2$, respectively. Hence, these two gates $X_5$ and $X_6$ cause loops within the fault tree 1, which make it problematic to automatically analyze the fault tree 1 as no meaningful Boolean expression can be readily assigned to the fault tree 1 due to the loop.

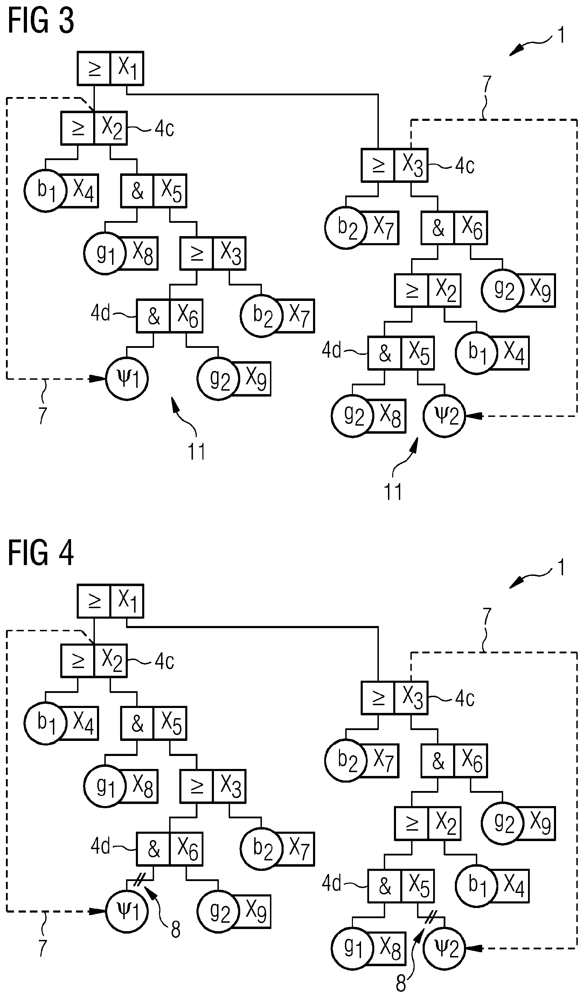

The method M further comprises under M2 back-tracing failure propagation paths 11 from the output element 4a of the fault tree 1 via the interconnections 2 towards the input elements 4b of the fault tree 1. This back-tracing is illustrated in Fig. 3, where it can be seen that the fault tree 1 is basically decomposed into two failure propagation paths 11, each of which features one closed loop 7. Or, to describe it differently, the fault tree 1 is "unrolled". The interconnection of each loop 7 to the respective failure propagation path 11 is labeled $\psi_i$ in the following. Hence, the failure propagation path 11 on the left in Fig. 3 has one closed loop 7 connecting one input of element $X_6$ with the output of element $X_2$ at loop interconnection $\psi_1$. Correspondingly, the failure propagation path 11 on the right in Fig. 3 has one closed loop 7 connecting one input of element $X_3$ with the output of element $X_3$ at loop interconnection $\psi_2$.

Such loop-causing gates may be identified in a general manner by checking for all failure propagation paths 11 if the respective failure propagation path 11 contains a downstream element 4d having a dependency of its output value on an output value of an upstream element 4c of the failure propagation path 11. Accordingly, the method M comprises under M3 checking, for all failure propagation paths 11, if the respective failure propagation path 11 contains a closed loop 7 by identifying a downstream element 4d of the respective failure propagation path 11 having a dependency of its output value on an output value of an upstream element 4c of the failure propagation path 11.

Next, the method M removes these two closed loops 7 in the fault tree 1. To this end, the method M comprises under M4 setting the input value corresponding to the loop interconnection $\psi_i$ of each such downstream element 4d to Boolean TRUE. Or, in other words, the problematic element turning up in a corresponding Boolean expression at this point is replaced by the expresson $\psi_i$. Further, the method comprises under M5 identifying any Boolean AND-gate 3a having, independently of the specific values of the input elements 4b, not Boolean TRUE as output. With reference to Fig. 4, it can be seen that two AND-gates 4da can be found that fulfill these criteria and, thus, two Boolean AND-gates 4da are identified.

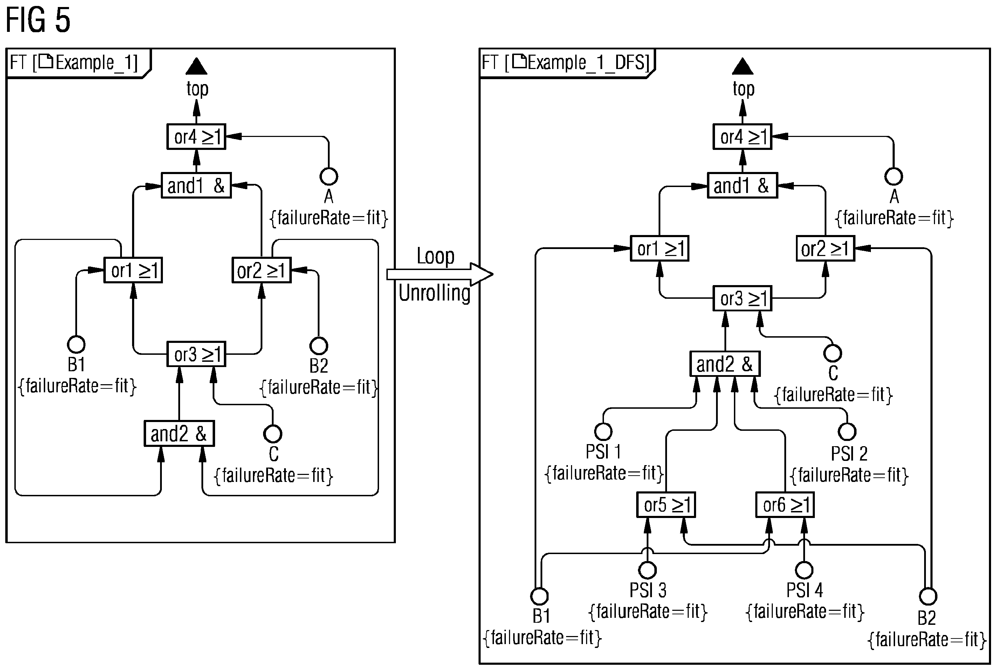

The method M further comprises under M5 cutting off any Boolean TRUE input to the identified Boolean AND-gate 3a remaining between the respective downstream element 4d and the upstream element 4c. As can be seen in Fig. 4, for both $X_6$ and $X_3$ one respective input is cut off, namely the loop interconnections $\psi_1$ and $\psi_2$ (denoted as cut interconnections 8 in Fig. 4). Finally, the method M comprises under M6 setting the input value of each respective downstream element 4d corresponding to the loop interconnection $\psi_i$ to Boolean FALSE. In this particular example, the loop interconnections $\psi_i$ are cut off anyway, hence this method step has no consequence (cf., however, the examples in Figs. 5 to 8). As can be seen in Fig. 4, the closed loops 7 have been removed, i.e. they have been cut off the failure propagation paths 11. Only well-defined Boolean gates 3 and basic events $b_i$, $g_i$ remain in the fault tree 1. Hence, the fault tree 1 in Fig. 2 can now be evaluated, that is, it can be iteratively expanded into definite Boolean expressions at the elements 4, proceeding from the output element 4a via the interconnections 2 towards the input elements 4b or vice versa. The fault tree 1 thus can be expressed as:

$$(b_1 \vee (g_1 \wedge (g_2 \vee b_2))) \vee (b_2 \vee (g_2 \wedge (b_1 \vee g_1)))$$

The method according to the invention can be summarized as follows with the pseudo code:

1. Identify all loops within the fault tree (using depth-first or depth-first search).

2. Break each loop by removing the connection between the loop causing gate and its predecessor and add a substitute basic event X. Set X = true.

3. For all loops:
Check for each of the AND gates within the loop, if the AND gate = true (tautology) or not

    i. If AND gate = true then do nothing
    ii. If AND gate is not true then remove all connections to its children which are true
    iii. Set all substitute basic events to false

The method can be used to determine the lower bound for the fault tree analysis.

Thereby, alternatively, the method step M5 can be modified as follows:
The step

- Checking M5 any Boolean AND-gate 3a having, independently of the specific values of the input elements 4b, Boolean TRUE as output value nothing has to be done
- the step of replacing M5 any Boolean AND-gate 3a having, independently of the specific values of the input elements 4b, Boolean TRUE as output value with a Boolean OR-gate 3b between the respective downstream element 4d and the respective upstream element 4c.

This alternative method step results in an upper bound of the fault tree analysis, as explained in detail in document EP 579 074 A1.

The upper bound and lower bound, accordingly, two bounds, can be used to judge the fault tree analysis result.

This can lead to the following exemplary use cases:

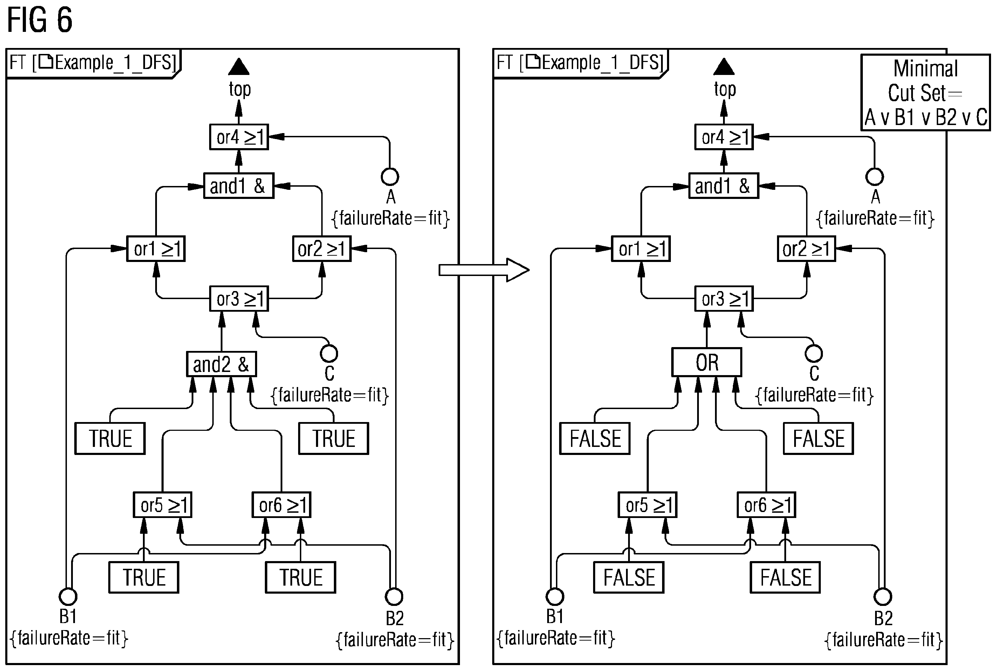

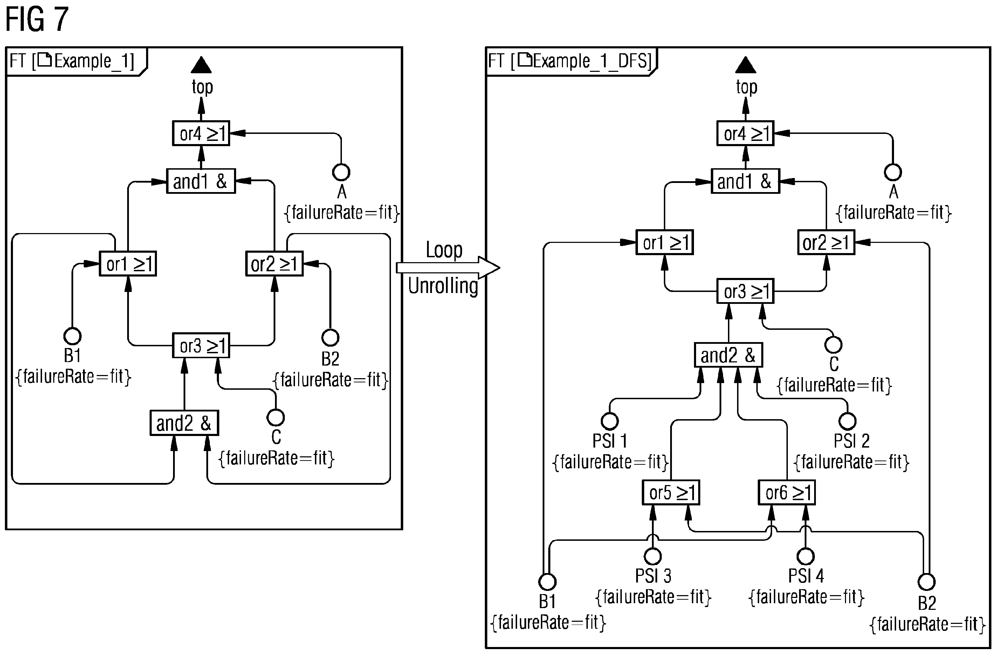

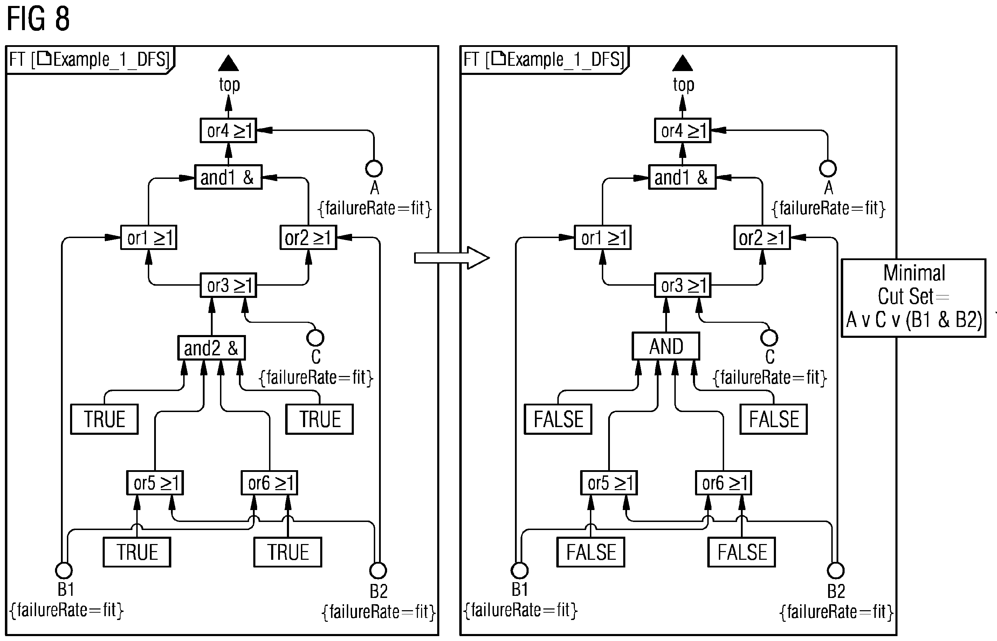

1. The upper and lower bounds of the fault tree analysis are equal, according to Figures 6 and 8, denoted as minimal cut set = A v B1 v B2 v C. Thereby, cut sets are the unique combinations of component failures that can cause system failure. Specifically, a cut set is said to be a minimal cut set if, when any basic event is removed from the set, the remaining events collectively are no longer a cut set. Hence, in this case, the loop breaking step according to Figures 5 and 7 leads to the same and also exact result. This result can be compared to the Tolerable Hazard Rate (THR) to judge, if the requirement is fulfilled (or not).

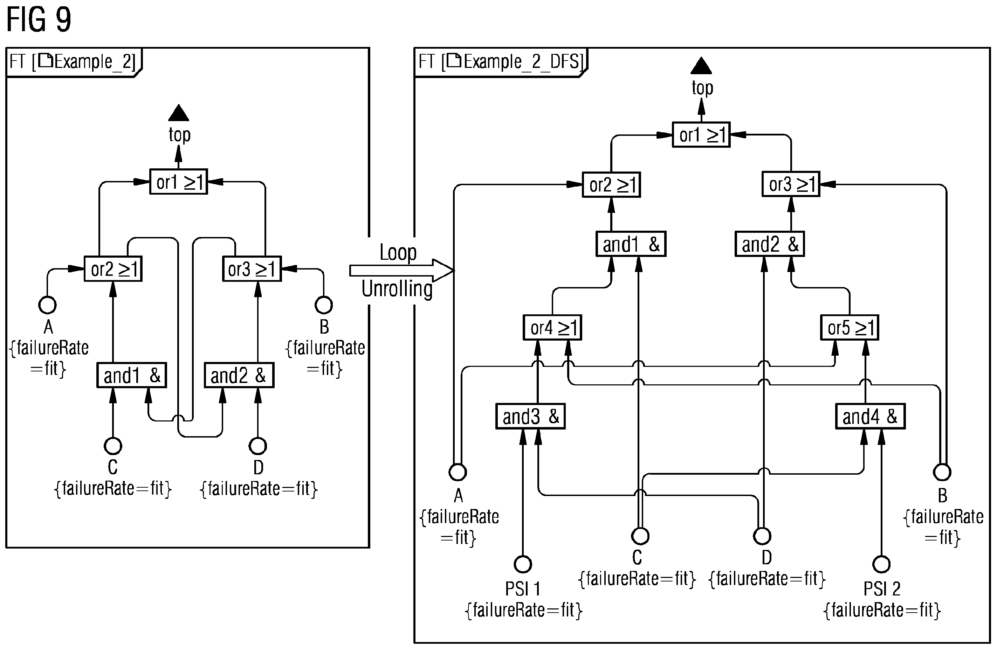

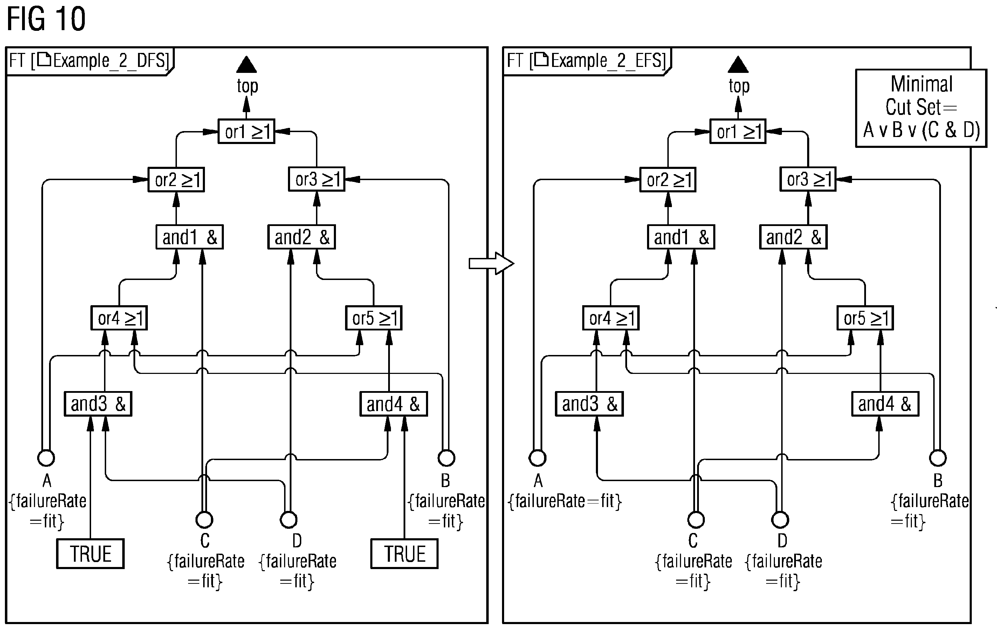

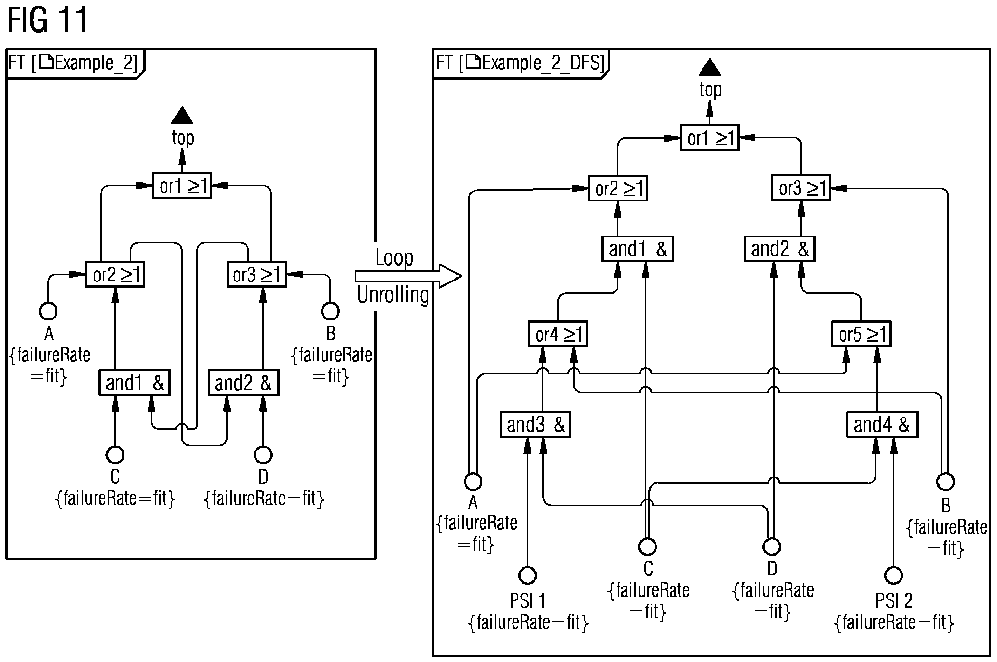

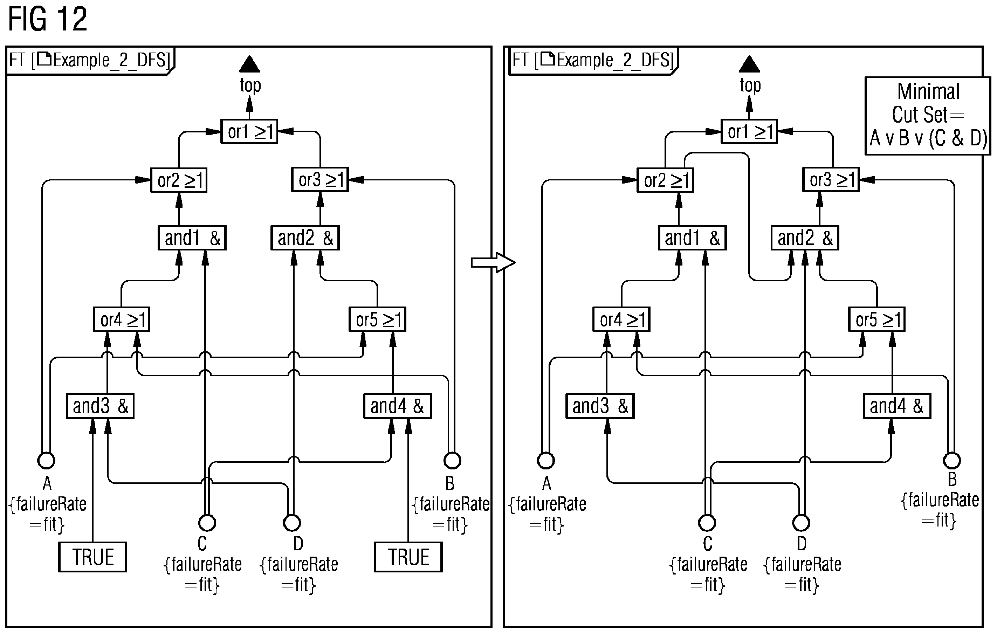

2. The upper and lower bounds of the fault tree analysis are different. In other words, in this case, the loop breaking according to Figures 9 and 11 leads to distinct results or bounds, denoted with distinct minimal cut sets. The minimal cut sets are shown in Figures 10 and 12, respectively.

In this case, distinct sub cases are possible

a. Upper bound is lower than the THR, the requirement is fulfilled
b. Lower bound is lower than the THR, the requirement is not fulfilled
c. The THR is between the lower and the upper bound. This means, that it is not sure, if the requirement is fulfilled or not. Hence, the fault tree can be postprocessed. For example, the fault tree is reviewed and/or checked by an expert or automatically, if loops can be removed by changing the reworking the fault tree. The removal of loops can be performed manually or automatically. Afterwards the fault tree analysis must be executed again and the lower and upper bound must compared to the THR.

**Claims**

1. A computer-implemented method (M) for resolving closed loops (7) in automatic fault tree analysis of a multi-component system, the method (M) comprising the steps:

    a. modeling (M1) the multi-component system using a fault tree (1), the fault tree (1) comprising elements (4) associated with components of the multi-component system and interconnections (2) between the elements (4) associated with functional dependencies between the components;
    b. back-tracing (M2) failure propagation paths (11) from an output element (4a) of the fault tree (1) via the interconnections (2) towards one or more input elements (4b) of the fault tree (1);
    c. checking (M3), for all failure propagation paths (11), if the respective failure propagation path (11) contains a closed loop (7) by identifying a downstream element (4d) of the respective failure propagation path (11) having a dependency of its output value on an output value of an upstream element (4c) of the failure propagation path (11);
    d. setting (M4) the input value corresponding to a loop interconnection ($\psi_i$) of each such downstream element (4d) to Boolean TRUE;
    **characterized in that**
    e. Identifying (M5) any Boolean AND-gate (3a) having, independently of the specific values of the input elements (4b), no Boolean TRUE as output value;
    f. cutting off (M5) any Boolean TRUE input to any identified Boolean AND-gate (3a) between the respective downstream element (4d) and the respective upstream element (4c); and
    g. setting (M6) the input value of each respective downstream element (4d) corresponding to the loop inter-connection ($\psi_i$) to Boolean FALSE.

2. The method (M) according to claim 1, wherein the fault tree (7) is expressed within Boolean algebra by iteratively expanding the fault tree (7) into Boolean expressions at the elements (4).

3. The method (M) according to claim 1 or 2, wherein the closed loop (7) of the fault tree (1) is associated with a closed-loop control circuitry of the multi-component system.

4. A device (10) comprising a processor (6) configured to perform a method (M) according to one of the claims 1 to 3.

**Patentansprüche**

1. Computerimplementiertes Verfahren (M) zum Auflösen von geschlossenen Schleifen (7) bei der automatischen Fehlerbaumanalyse eines Mehrkomponentensystems, wobei das Verfahren (M) die folgenden Schritte umfasst:

    a. Modellieren (MI) des Mehrkomponentensystems unter Verwendung eines Fehlerbaums (1), wobei der Fehlerbaum (1) Elemente (4), die mit Komponenten des Mehrkomponentensystems assoziiert sind, und Verbindungen (2) zwischen den Elementen (4), die mit funktionalen Abhängigkeiten zwischen den Komponenten assoziiert sind, umfasst;
    b. Zurückverfolgen (M2) von Fehlerfortpflanzungspfaden (11) von einem Ausgabeelement (4a) des Fehlerbaums (1) über die Verbindungen (2) in Richtung eines oder mehrerer Eingabeelemente (4b) des Fehlerbaums (1);
    c. Prüfen (M3), für alle Fehlerfortpflanzungspfade (11), durch Identifizieren eines nachgeschalteten Elements (4d) des jeweiligen Fehlerfortpflanzungspfads (11), das eine Abhängigkeit seines Ausgabewerts von einem Ausgabewert eines vorgeschalteten Elements (4c) des Fehlerfortpflanzungspfads (11) aufweist, ob der jeweilige Fehlerfortpflanzungspfad (11) eine geschossene Schleife (7) enthält;

d. Setzen (M4) des einer Schleifenverbindung ($\psi_i$) entsprechenden Eingabewerts jedes derartigen nachgeschalteten Elements (4d) zu boolesch TRUE;

**dadurch gekennzeichnet, dass**

e. Identifizieren (M5) jeglichen booleschen AND-Gatters (3a), das, unabhängig von den spezifischen Werten der Eingabeelemente (4b), kein boolesches TRUE als Ausgabewert aufweist;

f. Sperren (M5) jeglicher boolescher TRUE-Eingabe an jegliches identifizierte boolesche AND-Gatter (3a) zwischen dem jeweiligen nachgeschalteten Element (4d) und dem jeweiligen vorgeschalteten Element (4c); und

g. Setzen (M6) des der Schleifenverbindung ($\psi_i$) entsprechenden Eingabewerts jedes jeweiligen nachgeschalteten Elements (4d) zu boolesch FALSE.

2. Verfahren (M) nach Anspruch 1, wobei der Fehlerbaum (7) in boolescher Algebra durch iteratives Expandieren des Fehlerbaums (7) in boolesche Ausdrücke an den Elementen (4) ausgedrückt wird.

3. Verfahren (M) nach Anspruch 1 oder 2, wobei die geschlossene Schleife (7) des Fehlerbaums (1) mit einer Regelschaltung des Mehrkomponentensystems assoziiert ist.

4. Vorrichtung (10), umfassend einen Prozessor (6), der dazu konfiguriert ist, ein Verfahren (M) nach einem der Ansprüche 1 bis 3 auszuführen.


**Revendications**

1. Procédé (M) mis en œuvre par ordinateur pour résoudre des boucles fermées (7) dans une analyse automatique par arbre de défaillances d'un système à plusieurs composants, le procédé (M) comprenant les étapes :

a. modéliser (M1) le système à plusieurs composants en utilisant un arbre de défaillances (1), l'arbre de défaillances (1) comprenant des éléments (4) associés à des composants du système à plusieurs composants et des interconnexions (2) entre les éléments (4) associées à des dépendances fonctionnelles entre les composants ;

b. retracer (M2) des chemins de propagation de défaillance (11) depuis un élément de sortie (4a) de l'arbre de défaillances (1) par l'intermédiaire des interconnexions (2) vers un ou plusieurs éléments d'entrée (4b) de l'arbre de défaillances (1) ;

c. vérifier (M3), pour tous les chemins de propagation de défaillance (11), si le chemin de propagation de défaillance respectif (11) contient une boucle fermée (7) en identifiant un élément en aval (4d) du chemin de propagation de défaillance respectif (11) dont la valeur de sortie dépend d'une valeur de sortie d'un élément en amont (4c) du chemin de propagation de défaillance (11) ;

d. régler (M4) la valeur d'entrée correspondant à une interconnexion en boucle ($\Psi_i$) de chaque élément en aval (4d) de ce type sur la valeur booléenne VRAI ;

**caractérisé par**

e. identifier (M5) toute porte booléenne ET (3a) n'ayant, indépendamment des valeurs spécifiques des éléments d'entrée (4b), aucune valeur booléenne VRAI comme valeur de sortie ;

f. couper (M5) toute entrée booléenne VRAI vers toute porte booléenne ET (3a) identifiée entre l'élément en aval respectif (4d) et l'élément en amont respectif (4c) ; et

g. régler (M6) la valeur d'entrée de chaque élément en aval respectif (4d) correspondant à l'interconnexion en boucle ($\Psi_i$) sur la valeur booléenne FAUX.

2. Procédé (M) selon la revendication 1, dans lequel l'arbre de défaillances (7) est exprimé en algèbre booléenne par développement itératif de l'arbre de défaillances (7) en expressions booléennes au niveau des éléments (4).

3. Procédé (M) selon la revendication 1 ou 2, dans lequel la boucle fermée (7) de l'arbre de défaillances (1) est associée à un ensemble de circuits de commande en boucle fermée du système à plusieurs composants.

4. Dispositif (10) comprenant un processeur (6) configuré pour réaliser un procédé (M) selon l'une des revendications 1 à 3.

# FIG 1

# FIG 2

# FIG 3

# FIG 4

FIG 5

FIG 6

EP 4 260 152 B1

FIG 7

# FIG 8

FT [▢Example_1_DFS]

top

or4 ≥1

and1 &

A
{failureRate=fit}

or1 ≥1    or2 ≥1

or3 ≥1

and2 &    C
{failureRate=fit}

TRUE    TRUE

or5 ≥1    or6 ≥1

TRUE    TRUE

B1
{failureRate=fit}

B2
{failureRate=fit}

FT [▢Example_1_DFS]

top

or4 ≥1

and1 &

A
{failureRate=fit}

or1 ≥1    or2 ≥1

or3 ≥1

AND    C
{failureRate=fit}

FALSE    FALSE

or5 ≥1    or6 ≥1

FALSE    FALSE

B1
{failureRate=fit}

B2
{failureRate=fit}

Minimal
Cut Set=
A v C v (B1 & B2)

EP 4 260 152 B1

FIG 9

# FIG 10

FT [Example_2_DFS]

top

or1 ≥1

or2 ≥1     or3 ≥1

and1 &     and2 &

or4 ≥1     or5 ≥1

and3 &     and4 &

A
{failureRate
=fit}

TRUE

C
{failureRate
=fit}

D
{failureRate
=fit}

TRUE

B
{failureRate
=fit}

FT [Example_2_EFS]

top

or1 ≥1

or2 ≥1     or3 ≥1

and1 &     and2 &

or4 ≥1     or5 ≥1

and3 &     and4 &

A
{failureRate=fit}

C
{failureRate
=fit}

D
{failureRate
=fit}

B
{failureRate
=fit}

Minimal
Cut Set=
A v B v (C & D)

EP 4 260 152 B1

16

# FIG 11

EP 4 260 152 B1

# FIG 12

FT [Example_2_DFS]

Minimal Cut Set = A v B v (C & D)

top  or1 ≥1  or3 ≥1  and2 &  or5 ≥1  and4 &  B {failureRate =fit}
or2 ≥1  and1 &  or4 ≥1  and3 &  A {failureRate =fit}
C {failureRate =fit}  D {failureRate =fit}

FT [Example_2_DFS]

top  or1 ≥1  or3 ≥1  and2 &  or5 ≥1  and4 &  B {failureRate =fit}
or2 ≥1  and1 &  or4 ≥1  and3 &  A {failureRate =fit}
C {failureRate =fit}  D {failureRate =fit}
TRUE  TRUE

**EP 4 260 152 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3579074 A1

- EP 579074 A1

**Non-patent literature cited in the description**

- *Functional Safety of Electrical/Electronic/Programmable Electronic Safety-related Systems*, 1998
- **VESELY et al.** Fault Tree Handbook. *US Nuclear Regulatory Commission*, 1981
- **HÖFIG et al.** Streamlining Architectures for Integrated Safety Analysis Using Design Structure Matrices (DSMS). *Safety and Reliability: Methodology and Applications*, 2014
- **YANG et al.** Analytic Method to Break Logical Loops Automatically in PSA. *Reliability Engineering & System Safety*, 1997, vol. 56 (2), 101-105

- **CUENOT et al.** Proposal for extension of meta-model for error failure and propagation analysis. *Safe Automotive Software Architecture (SAFE), an ITEA2 project*, 2013
- **VAURIO et al.** A Recursive Method for Breaking Complex Logic Loops in Boolean System Models. *Reliability Engineering & System Safety*, 2007, vol. 92 (10), 1473-1475
- **LIM et al.** Systematic Treatment of Circular Logics in a Fault Tree Analysis. *Nuclear Engineering and Design*, 2012, vol. 245, 172-179
- **KAISER et al.** A new component concept for FTs. *Proceedings of the 8th Australian Workshop on Safety Critical Systems and Software*, 2003, vol. 33, 37-46